(19) Europäisches Patentamt
European Patent Office
Office européen des brevets

(11) **EP 2 549 556 B1**

(12) **EUROPEAN PATENT SPECIFICATION**

(45) Date of publication and mention
of the grant of the patent:
**22.04.2015 Bulletin 2015/17**

(51) Int Cl.:
***H01L 41/047*** (2006.01)

(21) Application number: **11174328.2**

(22) Date of filing: **18.07.2011**

(54) **Unidirectional piezoelectric transducer**

Einseitig gerichteter piezoelektrischer Wandler

Transducteur piézoélectrique monodirectionnel

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**23.01.2013 Bulletin 2013/04**

(73) Proprietor: **Luxembourg Institute of Science and
Technology
4362 Esch-sur-Alzette (LU)**

(72) Inventors:
• **Nasser, Houssein
4130 Esch/Alzette (LU)**
• **Belouettar, Salim
57070 Metz (FR)**

(74) Representative: **Lecomte, Didier
Lecomte & Partners
P.O. Box 1623
1016 Luxembourg (LU)**

(56) References cited:
**US-A- 5 806 159       US-A1- 2011 061 215
US-B1- 7 898 158**

## Description

Field of the invention

The present invention is directed to the technical field of piezoelectric transducers, i.e. actuators and/or sensors. In particular, piezoelectric sensors are provided to measure surface strains.

State of the art

A vast variety of piezoelectric transducer designs is known from the state of the art. In particular, it is known to embed a piezoelectric material between two planar surface electrodes and to either measure voltage generated by a mechanical deformation of the piezoelectric material (sensor function) or to apply a voltage to the electrodes in order to obtain a mechanical deformation of the piezoelectric material (actuator function).

Moreover, it is known to provide piezoelectric material between systems of interdigitated surface electrodes. Such an arrangement of mutually engaging electrodes is capable of generating or sensing an electrical field being in parallel with the piezoelectric material's surface, whereas planar electrodes as mentioned above generate or sense fields in a direction perpendicular to the surface of the piezoelectric material.

Unfortunately, a piezoelectric effect does not occur only in one direction of the piezoelectric material. In particular, a non-negligible transversal (in-plane) piezoelectric effect occurs as well. A measure for this transversal piezoelectric effect can be described by the piezoelectric constant $d_{32}$ giving basically the relationship between a polarization/electric field and a strain applied or measured in the given direction. When sensing or actuation in a unidirectional direction is required, the presence of this non-negligible transversal effect decreases either the sensing sensibility of the piezoelectric sensor or the accuracy and/or efficiency of the piezoelectric actuator.

Therefore, it is an object of the invention to overcome at least one of the above mentioned disadvantages. In particular, a unidirectional sensor and/or actuator shall be provided with a high sensing sensitivity in a direction of a measured strain and/or a high actuation efficiency or accuracy.

US 7,898,158 B1 discloses a piezoelectric transducer according to the preamble of appended claim 1.

US 2011/0061215 A1 discloses a process for fabricating a membrane comprising a piezoelectric actuator which has a piezoelectric material layer, two annular plate electrodes and a pair of bent interdigitated electrodes.

Summary of the invention

The above technical problem is solved by the transducer according to appended claim 1.

The (unidirectional) piezoelectric transducer (sensor / actuator) according to the invention comprises a piezoelectric material layer; two plate electrodes arranged on opposing sides of a first portion of the piezoelectric material layer; and at least one pair of interdigitated electrodes arranged on at least one side of a second portion of the piezoelectric material layer, wherein each pair of interdigitated electrodes is adapted to generate or sense an electrical field in a longitudinal direction substantially in parallel to the plane of the piezoelectric material layer. Still in accordance with the invention, the second portion is laterally contiguous to (juxtaposed / adjacent to) the first portion, i.e. essentially in a direction transversal with respect to the longitudinal direction. Each pair of interdigitated electrodes comprises two comb-shaped electrode members mutually engaging each other.

The inventors have found that providing a pair of planar electrodes and at least one pair of interdigitated electrodes in two neighboring (distinct) portions of a piezoelectric material decreases or may even cancel the effective (resulting) transversal piezoelectric effect, i.e. the effective $d_{32}$-effect of the piezoelectric transducer. Thus, it is possible to obtain with such a setup a measuring system having a higher sensing sensitivity than prior art transducers. In particular, the fact of providing both electrode types in a juxtaposed arrangement results in reducing or cancelling the effective electromechanical coupling in the transversal direction. The new transducer design is thus highly sensitive to the electromechanical coupling in the longitudinal field generating or sensing direction.

In accordance with another preferred aspect of the invention, each member of a pair of interdigitated electrodes comprises a plurality of parallel electrode fingers extending transversally to the longitudinal field sensing or generating direction on the surface of the piezoelectric material layer.

In accordance with another preferred aspect of the invention, the neighboring electrode fingers of the electrode members are spaced or separated at a distance in the longitudinal direction.

In accordance with another preferred aspect of the invention, the fingers of each electrode member are connected with each other at one of their ends by means of an electric conductor extending essentially in the longitudinal field sensing or generating direction, wherein the tips of the electrode fingers of one of the members and the opposed electric conductor of the other member are spaced or separated at a distance transversal to the longitudinal direction, comprised between one time the longitudinal distance between the neighboring electrode fingers and three times the longitudinal distance between the neighboring electrode fingers.

The inventors found that this arrangement of the comb-like electrode members allows for further decreasing the undesired effective or global transversal piezoelectric effect.

In accordance with another preferred aspect of the invention, the transversal distance deviates by less than 10% from two times the longitudinal distance between the neighboring electrode fingers. Such a small range of the described transversal distance is even more preferably.

In accordance with another preferred aspect of the invention, the (mutually) engaging electrode members define an area of (transversally) overlapping electrode fingers spaced from each other in the longitudinal direction. Preferably, this area has essentially a rectangular shape.

In accordance with another preferred aspect of the invention, the first portion and/or the second portion may have each an essentially rectangular shape, with both portions separated by a (strip-like) gap from each other. Providing such rectangular shapes of both portions covered by the electrodes, may further homogenize the fields generated and / or sensed by the electrodes.

$w_2$ is essentially transversal to the longitudinal field sensing or generating direction of the interdigitated electrodes; and

$$\frac{d}{h} \approx -\frac{d_{ll}}{d_{pl}},$$

wherein $d_{ll}$ and $d_{pl}$ are (defined / known) longitudinal effective electromechanical constants of the piezoelectric material layer, with $d_{ll}$ being the longitudinal effective electromechanical constant of the area of transversally overlapping electrode fingers, and $d_{pl}$ being the longitudinal effective electromechanical constant of the piezoelectric material layer of the first portion. Preferably, both ratios differ from each other in less than 20%.

As described in more detail below, $d_{ll}$ and $d_{pl}$ could also be described as $d_{33}$ for the area of overlapping electrode fingers and as $d_{31}$ for the first portion. The accurate verification of the mentioned equations would result in unidirectional sensing or actuation. However, in any case, providing the transducer according to the present invention results in a definitely increased sensing / actuation sensitivity in the longitudinal direction with respect to the transverse direction in comparison with prior art transducers.

In accordance with another preferred aspect of the invention, the fractions of each of the above mentioned relations deviate from each other by less than 5%, and preferably by less than 1%. As mentioned already above, best results could be achieved if both relations show equality.

In accordance with another preferred aspect of the invention, the piezoelectric material layer further comprises an arrangement of piezoelectric fibers embedded in a polymer matrix, the fibers being aligned in the longitudinal direction of the piezoelectric material layer and extending essentially perpendicular to the surface of piezoelectric material layer. Such an arrangement of the piezoelectric fibers can further optimize the sensitivity of the transducer by introducing an anisotropy perpendicular to the surface of the piezoelectric material layer. However, in general, it is possible to embed also bulk or monolithic piezoelectric materials between the surface electrodes. Moreover, the polymer matrix may provide a certain bendability or flexibility to the transducer so that the transducer might be brought into contact even with bended surfaces for actuating or measuring purposes.

All above aspects and features may be combined and/or replaced with each other.

Brief description of the drawings

In the following the figures of the present application are briefly described. Further details are given in the detailed description of the embodiments according to the invention.

Figure 1 a shows a schematic perspective view of a prior art piezoelectric transducer;

Figure 1b shows a schematic perspective view of another prior art piezoelectric transducer; and

Figure 2 shows a schematic perspective view of a piezoelectric transducer according to a preferred embodiment of the present invention.

Detailed description of the embodiments

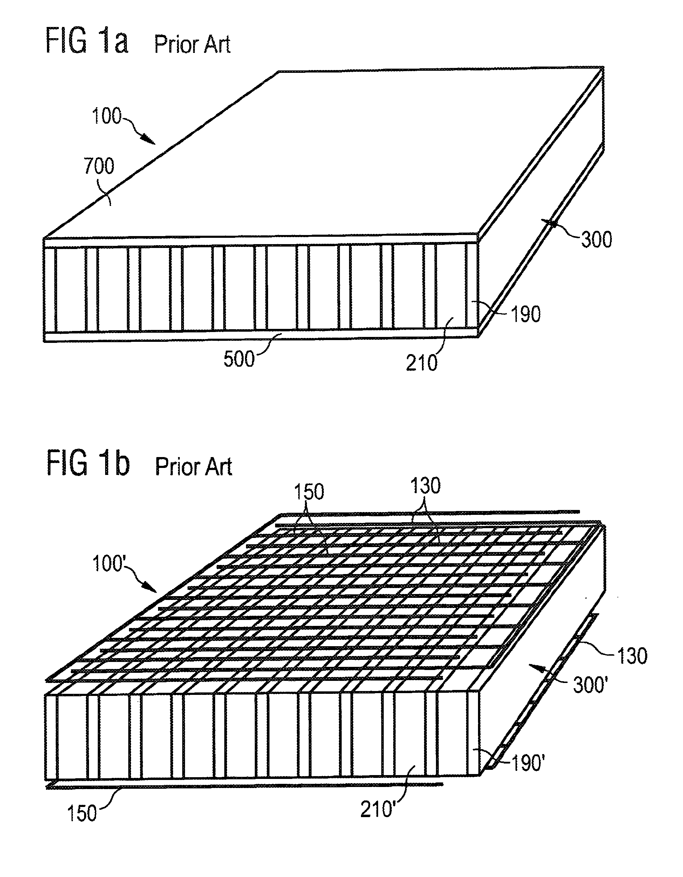

Figure 1 a discloses a first prior art piezoelectric transducer 100 (sensor and / or actuator). A piezoelectric layer (piezoelectric fiber composite or monolithic piezoelectric wafer) 300 is embedded between two conventional plate electrodes 500, 700 having opposite polarity. If a voltage is applied to the pair of these planar electrodes 500, 700, the piezoelectric layer 300 deforms due to the piezoelectric effect (substantially in a direction perpendicular to the surface of the piezoelectric layer 300). According to the depicted example of Figure 1a, the piezoelectric layer 300 is a piezoelectric fiber composite layer comprising piezoelectric fibers 210 aligned in one direction and embedded into a matrix 190.

Figure 1b discloses a second prior art piezoelectric transducer 100'. Again a piezoelectric layer 300' similar to the piezoelectric layer 300 according to Figure 1 a is embedded between two electrode assemblies 130, 150. In particular, on each side of the layer 300' is arranged a pair of interdigitated electrodes 130, 150. Such electrode pairs 130, 150 are in principle known and are capable of generating an electrical field in an in-plane direction of the piezoelectric layer 300'.

If the piezoelectric transducers 100 or 100' are deformed via a strain, an electrical potential can be measured at the electrodes 300, 500, or 130, 150 respectively.

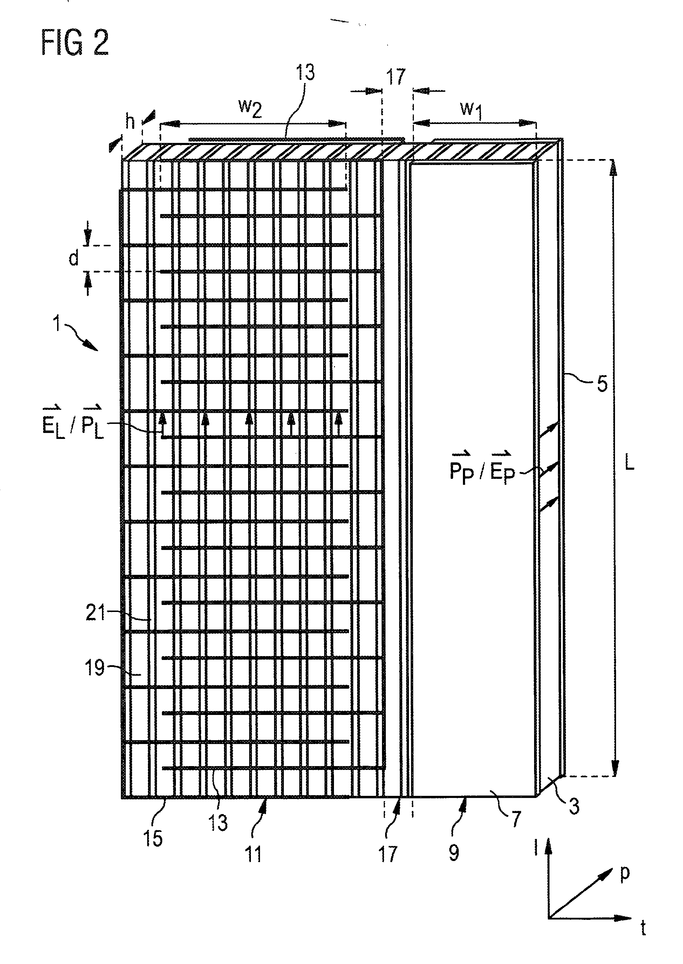

Figure 2 shows an exemplary embodiment of a piezoelectric transducer 1 according to the present invention. The transducer might be used as a sensor, i.e. for measuring surface-strains, or may be used as an actuator, i.e. to generate a deformation of the transducer 1. In particular, the transducer 1 comprises a piezoelectric (material) layer 3 which can be made of any piezoelectric bulk or composite material. One example of such a material is lead zirconate titanate (PZT). However, the present invention is not restricted to such a material. The actuator 1 comprises two (substantially laterally adjacent) portions or areas 9, 11. In the first portion 9, the piezoelectric layer is embedded or arranged between two planar electrodes 7, 5. In the second portion 11 of the piezoelectric layer 3, the latter is arranged or embedded between two pairs of interdigitated electrodes 13, 15. These areas may preferably be separated by a gap 17 in order to obtain a non-polarized zone between both portions 9 and 11. Thus, this surface area 17 of the piezoelectric layer does not comprise any electrodes. In other words, portion 17 forms an electrode-free area or strip of the piezoelectric layer 3. In general, and as shown in the present embodiment, the portions 11, 17, 9 of interdigitated electrodes, the gap, and the planar electrodes may cover substantially the complete surface of the piezoelectric layer 3.

The substrate or piezoelectric layer 3 has preferably a thickness h and preferably a length L. The length is measured preferably in a longitudinal direction l, whereas the thickness is measured in a direction p perpendicular to the layer's surface. The width of the substrate 3, measured in the (in-plane) transversal direction t, could be the sum of the width of the portion 11 exhibiting the interdigitated electrodes, the width $w_1$ of the portion 9 exhibiting the planar electrodes, and the width of the gap 17, if any. In particular, both portions 9, 11 could have an essentially rectangular shape. The same applies to the piezoelectric layer 3.

Although the width of gap 17 is shown in the order of the periodicity d of the interdigitated electrodes or in other words, in the order of the distance between two parallel electrode fingers, the gap width preferably corresponds to twice the periodicity d of the interdigitated electrodes 13, 15 in order to ensure a minimal electric field due to the difference in the electric potential between both kinds of electrodes.

As depicted in Figure 2, the interdigitated electrodes 13, 15 may comprise comb-like structures of electrodes. In particular, the interdigitated electrodes 13, 15 may comprise a plurality of substantially parallel electrode fingers extending essentially in the transversal direction t, wherein fingers of two different comb-like electrode structures engage (without contacting each other). The fingers of the electrodes are preferably connected with each other at their ends in the longitudinal direction l. The fingers or comb-like structures engaging essentially in the transverse direction form an area of overlapping electrode fingers. This area has preferably a width $w_2$.

It is remarked that the wording "interdigitated electrodes" is commonly used in general for the arrangement of electrodes 13, 15 as shown in the second portion 11 of the piezoelectric material layer 3 of Figure 2. The interdigitated electrodes may generate an electrical field $E_L$ and may induce a polarization $P_L$ in the longitudinal direction l, i.e. in the electrical field sensing or generating direction. Moreover, the planar electrodes 5, 7 may generate an electrical field Ep, and a polarization Pp respectively, in a direction substantially perpendicular to the surface of the piezoelectric material layer 3.

The electrodes as such could be made of any conventional material, as for example, copper, silver or gold, etc.

The piezoelectric material shown in Figure 2 is depicted as a macro fiber composite material usually comprising piezoelectric fiber material 19 embedded in an epoxy matrix 21. Such composites of a matrix 21 and a piezoelectric fiber material 19 can be used in order to introduce anisotropy in the perpendicular direction p which might be helpful in further improving the sensitivity of the measurement in the longitudinal direction l or the perpendicular direction p as well as in providing a flexible piezoelectric transducer. However, it is also possible to use a (homogeneous) monolithic piezoelectric material between both electrode structures.

The inventors found that the non-negligible transversal piezoelectric effect disturbs especially the in-plane sensitivity of the actuator and that the effect may be reduced by a neighboring or juxtaposed arrangement of interdigitated surface electrodes 13, 15 and plate electrodes 5, 7 on a piezoelectric material layer 3.

In addition, the inventors found that for further improving the unidirectional sensing and actuation, the following set of equations should be fulfilled:

$$(1) \quad \frac{d}{h} \approx \frac{w_1}{w_2};$$

$$(2) \quad \frac{d}{h} \approx -\frac{d_{33}}{d_{31}},$$

wherein $d_{33}$ and $d_{31}$ are piezoelectric material constants of the utilized piezoelectric material for the second portion and the first portion, respectively. These could also be effective values of composite material. Such constants are either known or may be calculated by the person skilled in the art. The constants $d_{xy}$ are also described as the piezoelectric charge constants. In particular, these (dimensionless) constants basically describe the linear relationship or conversion between electrical and mechanical energy. In particular, the first index of these constants denotes the direction of the electrical field or polarization and the second index denotes the direction of a mechanical strain or deformation. This notation is common practice in describing piezoelectric materials. In other parts of the present patent application, the indexes 1, 2 and 3 have been replaced by p, t and I for the sake of clarity and in order to clearly identify these directions with respect to the present transducer. In particular, strain is preferably applied in the index I and t directions of the sample (in-plane).

Preferably, the first equation (1) may be imposed in order to obtain a zero effective transversal strain (in direction t) of the transducer, whereas the second equation (2) may be imposed in order to provide uniformity of the longitudinal strain component within the both portions in direction I, when electric potentials are applied to the planar electrodes and the at least one pair of interdigitated electrodes.

In the first portion of the planar electrode, the in-plane deformations in directions I and t are proportional to $d_{31}$ and $d_{32}$ piezoelectric constants respectively, wherein the index 3 corresponds to the perpendicular field generating direction and index 1 corresponds to the longitudinal direction I and index 2 corresponds to the transversal direction. Whereas, in the second portion, where the at least one pair of interdigitated electrodes is used, the in-plane deformations in directions I and t are proportional to the $d_{33}$ and $d_{32}$ constants respectively, wherein 3 is the longitudinal field generating direction I and 2 is the transversal direction t. In general, for piezoelectric material, the electromechanical constants $d_{31}$ and $d_{32}$ have an opposite sign with respect to constant $d_{33}$.

Thus, according to the present invention, best results may be achieved if both above conditions are strictly met. However, in order to obtain improved results with respect to earlier transducers, it is not necessary to strictly meet both conditions. Deviations are possible. For example, both ratios could preferably differ from each other in less than twenty percent to obtain still superior sensing or actuating properties.

It is emphasized that details or single features of the above mentioned embodiments could also be combined with other aspects of the invention.

List of reference signs

| 1 | unidirectional piezoelectric transducer |
|---|---|
| 3 | piezo fiber composite material layer / piezoelectric material layer |
| 5 | plate/planar electrode |
| 7 | plate/planar electrode |
| 9 | first portion |
| 11 | second portion |
| 13 | electrode |
| 15 | electrode |
| 17 | gap |
| 19 | piezoelectric fiber material |
| 21 | polymer matrix |
| 100 | prior art piezoelectric transducer |
| 100' | prior art piezoelectric transducer |
| 300 | piezoelectric layer |
| 300' | piezoelectric layer |
| 500 | planar electrode |
| 700 | planar electrode |
| 130 | electrode |
| 150 | electrode |
| 190 | matrix |
| 190' | matrix |
| 210 | piezoelectric fiber |
| 210' | piezoelectric fiber |
| h | thickness of piezoelectric material layer |
| I | longitudinal direction / direction in parallel to the field sensing or generating direction |
| L | length of the substrate |
| d | periodicity of the interdigitated electrodes in the longitudinal direction |
| p | direction perpendicular to the surface of the piezoelectric material layer |
| t | transversal direction / width direction / direction perpendicular to the field sensing or generating direction |
| $w_1$ | width of the first portion in the transversal direction |
| $w_2$ | width of the second portion of the interdigitated electrodes |
| $E_L$ | electrical field in the longitudinal direction |
| Ep | electrical field in the perpendicular direction |

**Claims**

1. A piezoelectric transducer (1) comprising:

    a piezoelectric material layer (3) having a first portion (9) and a second portion (11); and at least one pair of interdigitated electrodes (13, 15) arranged on at least one side of the second portion (11) of the piezoelectric material layer (3), each pair of interdigitated electrodes (13, 15) comprises two comb-shaped electrode members (13, 15) mutually engaging each other, and is adapted to generate or sense an electrical field in a longitudinal direction (I) substantially in parallel to the plane of the piezoelectric material layer (3)
    **characterized in that**
    the piezoelectric transducer (1) further comprises two plate electrodes (5, 7) arranged on opposing sides of the first portion (9) of the piezoelectric material layer (3), wherein the second portion (11) is laterally contiguous to the first portion (9), essentially in a direction (t) transversal with respect to the longitudinal direction (I).

2. The piezoelectric transducer according to claim 1, wherein each member (13, 15) of a pair of interdigitated electrodes (13, 15) comprises a plurality of parallel electrode fingers extending transversally to the longitudinal field sensing or generating direction (I) on the surface of the piezoelectric material layer (3).

3. The piezoelectric transducer according to claim 1 or 2, wherein neighboring electrode fingers of the electrode members (13, 15) are separated at a distance (d) in the longitudinal direction (I).

4. The piezoelectric transducer according to claim 3, wherein the fingers of each electrode member (13, 15) are connected with each other at one of their ends by means of an electric conductor extending essentially in the longitudinal field sensing or generating direction (I), wherein
the tips of the electrode fingers of one of the members (13, 15) and the opposed electric conductor of the other members (15, 13) are separated at a distance transversal to the longitudinal direction (I) comprised between one time the longitudinal distance between the neighboring electrode fingers (d) and three times the longitudinal distance between the neighboring electrode fingers (d).

5. The piezoelectric transducer according to claim 4, wherein the transversal distance deviates by less than 10% from two times the longitudinal distance between the neighboring electrode fingers (d).

6. The piezoelectric transducers according to one of the claims 1 to 5, wherein the mutually engaging electrode members (13, 15) define an area of transversally overlapping electrode fingers spaced from each other in the longitudinal direction (I).

7. The piezoelectric transducer according to one of the preceding claims, wherein the first portion (9) and the second portion (11) are separated from each other by a strip-like third portion (17) of the piezoelectric material layer, the third portion (17) extending essentially in the longitudinal direction (I).

8. The piezoelectric transducer according to claim 7 in combination with one of the claims 4 to 7, wherein the third portion (17) has an in-plane width, transversal to the longitudinal field sensing or generating direction (I) of the pair of interdigitated electrodes (13, 15), of between the longitudinal distance of two neighboring electrode fingers (d) and three times the longitudinal distance of two neighboring electrode fingers (d).

9. The piezoelectric transducer according to claim 8, wherein the transversal width of the third portion (17) is substantially equal to two times the longitudinal distance between two neighboring electrode fingers (d).

10. The piezoelectric transducer according to one of the preceding claims, wherein a pair of interdigitated electrodes (13, 15) is arranged on each of the opposing sides of the second portion (11) of the piezoelectric material layer (3).

11. The piezoelectric transducer according to one of claims 6 to 10, wherein at least one of the following relations applies:

$$\frac{d}{h} \approx \frac{w_1}{w_2}$$

wherein d is the distance of the two neighboring electrode fingers in the longitudinal field sensing or generating direction (I), h is the thickness of the piezoelectric material layer (3), $w_1$ is the width of the plate electrodes (5, 7) essentially transversal to the longitudinal field sensing or generating direction (I) of the interdigitated electrodes (13, 15), and $w_2$ is the width of the area of transversally overlapping electrode fingers of the second portion (11), $w_2$ being essentially transversal to the longitudinal field sensing or generating direction (I) of the interdigitated electrodes (13, 15); and

$$\frac{d}{h} \approx -\frac{d_{ll}}{d_{pl}}$$

wherein $d_{ll}$ and $d_{pl}$ are longitudinal electromechanical constants of the piezoelectric material layer (3), with $d_{ll}$ being the longitudinal electromechanical constant of the area of transversally overlapping electrode fingers, and $d_{pl}$ being the longitudinal electromechanical constant of the first portion (9); and wherein the fractions of each of the relations deviate from each other by maximum 20%.

12. The transducer according to claim 11, wherein the fractions of each of the relations deviate from each other by less than 5%, and preferably by less than 1%.

13. The transducer according to one of the preceding claims, wherein the piezoelectric material layer (3) further comprises an arrangement of piezoelectric fibers (19) embedded in a polymer matrix (20), the fibers being aligned in the longitudinal direction (I) of the piezoelectric material layer (3) and extending essentially perpendicular to the surface of piezoelectric material layer (3).

**Patentansprüche**

1. Piezoelektrischer Wandler (1), umfassend:

   eine piezoelektrische Materialschicht (3) mit einem ersten Teil (9) und einem zweiten Teil (11); und
   mindestens ein Paar interdigitierter Elektroden (13, 15), die an mindestens einer Seite des zweiten Teils (11) der piezoelektrischen Materialschicht (3) angeordnet sind, wobei jedes Paar interdigitierter Elektroden (13, 15) zwei kammförmige Elektrodenelemente (13, 15) umfasst, die ineinandergreifen, und dazu eingerichtet ist, ein elektrisches Feld in einer Längsrichtung (I) im Wesentlichen parallel zur Ebene der piezoelektrischen Materialschicht (3) zu erzeugen oder zu erfassen,
   **dadurch gekennzeichnet, dass**
   der piezoelektrische Wandler (1) weiter zwei Plattenelektroden (5, 7) umfasst, die an gegenüberliegenden Seiten des ersten Teils (9) der piezoelektrischen Materialschicht (3) angeordnet sind, wobei der zweite Teil (11) seitlich an den ersten Teil (9) anschließt, im Wesentlichen in einer Richtung (t) transversal in Bezug zu der Längsrichtung (I).

2. Piezoelektrischer Wandler nach Anspruch 1, wobei jedes Element (13, 15) eines Paars interdigitierter Elektroden (13, 15) eine Vielzahl paralleler Elektrodenfinger umfasst, die sich transversal zu der Feld-Erfassungs- oder Erzeugungs-Längsrichtung (I) an der Oberfläche der piezoelektrischen Materialschicht (3) erstrecken.

3. Piezoelektrischer Wandler nach Anspruch 1 oder 2, wobei benachbarte Elektrodenfinger der Elektrodenelemente (13, 15) in einem Abstand (d) in der Längsrichtung (I) getrennt sind.

4. Piezoelektrischer Wandler nach Anspruch 3, wobei die Finger jedes Elektrodenelements an einem ihrer Enden mittels eines elektrischen Leiters, der sich im Wesentlichen in der Feld-Erfassungs- oder Erzeugungs-Längsrichtung (I) erstreckt, miteinander verbunden sind, wobei
   die Spitzen der Elektrodenfinger eines der Elemente (13, 15) und der entgegengesetzte elektrische Leiter anderer Elemente (15, 13) in einem Abstand transversal zu der Längsrichtung (I) voneinander getrennt sind, der zwischen einmal der Längsabstand zwischen den benachbarten Elektrodenfingern (d) und dreimal der Längsabstand zwischen den benachbarten Elektrodenfingern (d) beträgt.

5. Piezoelektrischer Wandler nach Anspruch 4, wobei der transversale Abstand um weniger als 10% von zweimal dem Längsabstand zwischen den benachbarten Elektrodenfingern (d) abweicht.

6. Piezoelektrischer Wandler nach einem der Ansprüche 1 bis 5, wobei die ineinandergreifenden Elektrodenelemente (13, 15) ein Gebiet transversal überlappender Elektrodenfinger, die in der Längsrichtung (I) voneinander beabstandet sind, definieren.

7. Piezoelektrischer Wandler nach einem der vorgenannten Ansprüche, wobei der erste Teil (9) und der zweite Teil (11) durch einen streifenartigen dritten Teil (17) der piezoelektrischen Materialschicht voneinander getrennt sind, wobei der dritte Teil (17) sich im Wesentlichen in der Längsrichtung (I) erstreckt.

8. Piezoelektrischer Wandler nach Anspruch 7 in Kombination mit einem der Ansprüche 4 bis 7, wobei der dritte Teil (17) eine Breite innerhalb der gleichen Ebene, transversal zu der Feld-Erfassungs- oder Erzeugungs-Längsrichtung (I) des Paars interdigitierter Elektroden (13, 15), von zwischen dem Längsabstand zweier benachbarter Elektrodenfinger (d) und dreimal dem Längsabstand zweier benachbarter Elektrodenfinger (d) aufweist.

9. Piezoelektrischer Wandler nach Anspruch 8, wobei die transversale Breite des dritten Teils (17) im Wesentlichen gleich zweimal dem Längsabstand zwischen zwei benachbarten Elektrodenfingern (d) ist.

10. Piezoelektrischer Wandler nach einem der vorgenannten Ansprüche, wobei ein Paar interdigitierter Elektroden (13, 15) an jeder der gegenüberliegenden Seiten des zweiten Teils (11) der piezoelektrischen Materialschicht (3) angeordnet ist.

11. Piezoelektrischer Wandler nach einem der Ansprüche 6 bis 10, wobei mindestens eine der folgenden Relationen gilt:

$$\frac{d}{h} \approx \frac{w_1}{w_2}$$

wobei d der Abstand der zwei benachbarten Elektrodenfinger in der Feld-Erfassungs- oder Erzeugungs-Längsrichtung (I) ist, h die Dicke der piezoelektrischen Materialschicht (3) ist, $w_1$ die Breite der Plattenelektroden (5, 7) im Wesentlichen transversal zu der Feld-Erfassungs- oder Erzeugungs-Längsrichtung (I) der interdigitierten Elektroden (13, 15) ist, und $w_2$ die Breite des Gebiets transversal überlappender Elektrodenfinger des zweiten Teils (11) ist, wobei $w_2$ im Wesentlichen transversal zu der Feld-Erfassungs- oder Erzeugungs-Längsrichtung

(l) der interdigitierten Elektroden (13, 15) ist; und

$$\frac{d}{h} \approx \frac{d_{ll}}{d_{pl}}$$

wobei $d_{ll}$ und $d_{pl}$ längsgerichtete elektromagnetische Konstanten der piezoelektrischen Materialschicht (3) sind, wobei $d_{ll}$ die längsgerichtete elektromagnetische Konstante des Gebiets transversal überlappender Elektrodenfinger ist und $d_{pl}$ die längsgerichtete elektromagnetische Konstante des ersten Teils (9) ist; und
wobei die Bruchzahlen jeder der Relationen um maximal 20% voneinander abweichen.

12. Wandler nach Anspruch 11, wobei die Bruchzahlen jeder der Relationen um weniger als 5% und bevorzugt um weniger als 1% voneinander abweichen.

13. Wandler nach einem der vorgenannten Ansprüche, wobei die piezoelektrische Materialschicht (3) weiter eine Anordnung von in eine Polymermatrix (20) eingebetteten piezoelektrischen Fasern (19) umfasst, wobei die Fasern in der Längsrichtung (l) der piezoelektrischen Materialschicht (3) ausgerichtet sind und sich im Wesentlichen senkrecht zur Oberfläche der piezoelektrischen Materialschicht (3) erstrecken.

**Revendications**

1. Transducteur piézo-électrique (1) comprenant :

une couche de matière piézo-électrique (3) possédant une première portion (9) et une deuxième portion (11) ; et
au moins une paire d'électrodes interdigitées (13, 15) arrangée sur au moins un côté de la deuxième portion (11) de la couche de matière piézo-électrique (3), chaque paire d'électrodes interdigitées (13, 15) comprenant deux membres en forme de peigne faisant office d'électrodes (13, 15) insérés l'un dans l'autre et étant conçue pour générer ou détecter un champ électrique dans une direction longitudinale (l) essentiellement en parallèle au plan de la couche de matière piézo-électrique (3) ;
**caractérisé en ce que** le transducteur piézo-électrique (1) comprend en outre deux électrodes à plaques (5, 7) arrangées sur les côtés opposés de la première portion (9) de la couche de matière piézo-électrique (3), la deuxième portion (11) étant contiguë en direction latérale à la première portion (9), essentiellement dans une direction (t) transversale par rapport à la direction longitudinale (l).

2. Transducteur piézo-électrique selon la revendication 1, dans lequel chaque membre (13, 15) d'une paire d'électrodes interdigitées (13, 15) comprend plusieurs doigts d'électrodes parallèles s'étendant en direction transversale par rapport à la direction longitudinale (l) détectant ou générant un champ sur la surface de la couche de matière piézo-électrique (3).

3. Transducteur piézo-électrique selon la revendication 1 ou 2, dans lequel des doigts d'électrodes voisins des membres (13, 15) faisant office d'électrodes sont séparés sur une distance (d) dans la direction longitudinale (l).

4. Transducteur piézo-électrique selon la revendication 3, dans lequel les doigts de chaque membre (13, 15) faisant office d'électrode sont reliés les uns aux autres à une de leurs extrémités au moyen d'un conducteur électrique s'étendant essentiellement dans la direction longitudinale (l) détectant ou générant un champ ; dans lequel
les extrémités des doigts d'électrodes d'un des membres (13, 15) et le conducteur électrique opposé de l'autre membre (13, 15) sont séparés sur une distance, transversale par rapport à la direction longitudinale (l), comprise entre une fois la distance longitudinale séparant les doigts d'électrons voisins (d) et trois fois la distance longitudinale séparant les doigts d'électrons voisins (d).

5. Transducteur piézo-électrique selon la revendication 4, dans lequel la distance transversale dévie à concurrence de moins de 10 % par rapport à deux fois la distance longitudinale séparant les doigts d'électrons voisins (d).

6. Transducteur piézo-électrique selon l'une quelconque des revendications 1 à 5, dans lequel les membres faisant office d'électrodes (13, 15) insérés l'un dans l'autre définissent une zone de doigts d'électrodes se chevauchant en direction transversale, espacés les uns des autres dans la direction longitudinale (l).

7. Transducteur piézo-électrique selon l'une quelconque des revendications précédentes, dans lequel la première portion (9) et la deuxième portion (11) sont séparées l'une de l'autre par une troisième portion (17) de la couche de matière piézo-électrique, en forme de bande, la troisième portion (17) s'étendant essentiellement dans la direction longitudinale (l).

8. Transducteur piézo-électrique selon la revendication 7, en combinaison avec une des revendications 4 à 7, dans lequel la troisième portion (17) possède une largeur dans le plan, en direction transversale par rapport à la direction longitudinale (I) détectant ou générant un champ, de la paire d'électrodes interdigitées (13, 15), qui représente une valeur qui se situe entre la distance longitudinale de deux doigts d'électrodes voisins (d) et trois fois la distance longitudinale de deux doigts d'électrodes voisins (d).

9. Transducteur piézo-électrique selon la revendication 8, dans lequel la largeur transversale de la troisième portion (17) est essentiellement égale à deux fois la distance longitudinale de deux doigts d'électrodes voisins (d).

10. Transducteur piézo-électrique selon l'une quelconque des revendications précédentes, dans lequel une paire d'électrodes interdigitées (13, 15) est arrangée sur chacun des côtés opposés de la deuxième portion (11) de la couche de matière piézo-électrique (3).

11. Transducteur piézo-électrique selon l'une quelconque des revendications 6 à 10, dans lequel au moins une des équations suivantes s'applique :

$$\frac{d}{h} \approx \frac{w_1}{w_2}$$

dans laquelle d représente la distance des deux doigts d'électrodes voisins dans la distance longitudinale (I) détectant ou générant un champ (I), h représente l'épaisseur de la couche de matière piézo-électrique (3), $w_1$ représente la largeur des électrodes à plaques (5, 7) essentiellement transversale par rapport à la direction longitudinale (I) détectant ou générant un champ, des électrodes interdigitées (13, 15), et $w_2$ représente la largeur de la zone de doigts d'électrodes se chevauchant en direction transversale, de la deuxième portion (11), $w_2$ s'étendant essentiellement en direction transversale par rapport à la direction longitudinale (I) détectant ou générant un champ, des électrodes interdigitées (13, 15) ; et

$$\frac{d}{h} \approx -\frac{d_{ll}}{d_{pl}}$$

dans laquelle $d_{ll}$ et $d_{pl}$ représentent des constantes électromécaniques longitudinales de la couche de matière piézo-électrique (3), $d_{ll}$ représentant la constante électromécanique longitudinale de la zone de doigts d'électrodes se chevauchant en direction transversale, et $d_{pl}$ représentant la constante électromécanique longitudinale de la première portion (9) ; et dans lequel les fractions de chacune des équations dévient l'une de l'autre à concurrence d'une valeur maximale de 20 %.

12. Transducteur selon la revendication 11, dans lequel les fractions de chacune des équations dévient l'une de l'autre à concurrence d'une valeur inférieure à 5 %, et de préférence inférieure à 1 %.

13. Transducteur selon l'une quelconque des revendications précédentes, dans lequel la couche de matière piézo-électrique (3) comprend en outre un arrangement de fibres piézo-électriques (19) insérées dans une matrice polymère (20), les fibres étant disposées en alignement dans la direction longitudinale (I) de la couche de matière piézo-électrique (3) et s'étendant essentiellement perpendiculairement à la surface de la couche de matière piézo-électrique (3).

FIG 1a   Prior Art

FIG 1b   Prior Art

# FIG 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7898158 B1

- US 20110061215 A1